# EUROPEAN PATENT APPLICATION

(11) **EP 1 659 847 A2**
(43) Date of publication of application: **24.05.2006**
(21) Application number: 05090308.7
(22) Date of filing: 10.11.2005
(51) Int. Cl.: H05K 9/00

(54) **Electromagnetic shield case**

(30) Priority: 22.11.2004 JP 2004337327
(71) Applicant: NEC CORPORATION, Minato-ku, Tokyo 108-01 (JP)
(72) Inventor: Nakano, Yasushi, Kakegawa-shi Shizuoka (JP)
(74) Representative: Wenzel & Kalkoff

(57) **Abstract**

An electronic apparatus, which includes an electromagnetic shield case supported on a circuit board, and a conductive component electrically connected to the electromagnetic shield case, for intimately contacting and sealing a gap of the electromagnetic shield case, is provided. Therefore electromagnetic shielding of the electronic apparatus is achieved using the conductive component that is used as the structural reinforcement component and also used for the purpose of shielding the gap of the electromagnetic shield case.

## Description

### BACKGROUND OF THE INVENTION

### 1. Field of the Invention

The present invention relates to an electronic apparatus having a shield structure in which a shield for improving electromagnetic shielding property is also used as a mechanical reinforcement.

### 2. Description of Related Art

A wireless terminal intentionally emits an electromagnetic wave from an antenna for the purpose of communication. Besides such intentional emission of the electromagnetic wave, a circuit of an electronic apparatus including the wireless terminal emits unnecessary electromagnetic waves. There is a possibility that unnecessary electromagnetic waves from the circuit of the electronic apparatus leak to the outside of the electronic apparatus, and adversely affect other electronic apparatuses. A method of restricting such unintentional leakage of the electromagnetic wave to the outside has been proposed as a method of shielding the electromagnetic wave. For example, in JP 10-276817 A and JP 11-4091 A, it has been proposed to accommodate a cellular phone in an electromagnetic shield case for using the cellular phone.

In JP 11-4091 A and JP 10-276817 A, the cellular phone to be shielded is covered with a shield case, and leakage of the electromagnetic wave to the outside is thus prevented. However, according to this method, in a compact electronic apparatus especially in a downsized and weight-saved cellular phone, portability and design style thereof are degraded.

Further, in JP 2001-352388 A, the entire circuit board on which electronic parts are mounted is surrounded by a shield case. According to this method, the size of the shield case is larger than the circuit board since the shield case surrounds the entire circuit board. Owing to the necessity to accommodate such a large shield case in a housing, the size of the apparatus becomes larger. In terms of downsizing the apparatus, a problem is inherent in the method of accommodating the entire circuit board in the shield case.

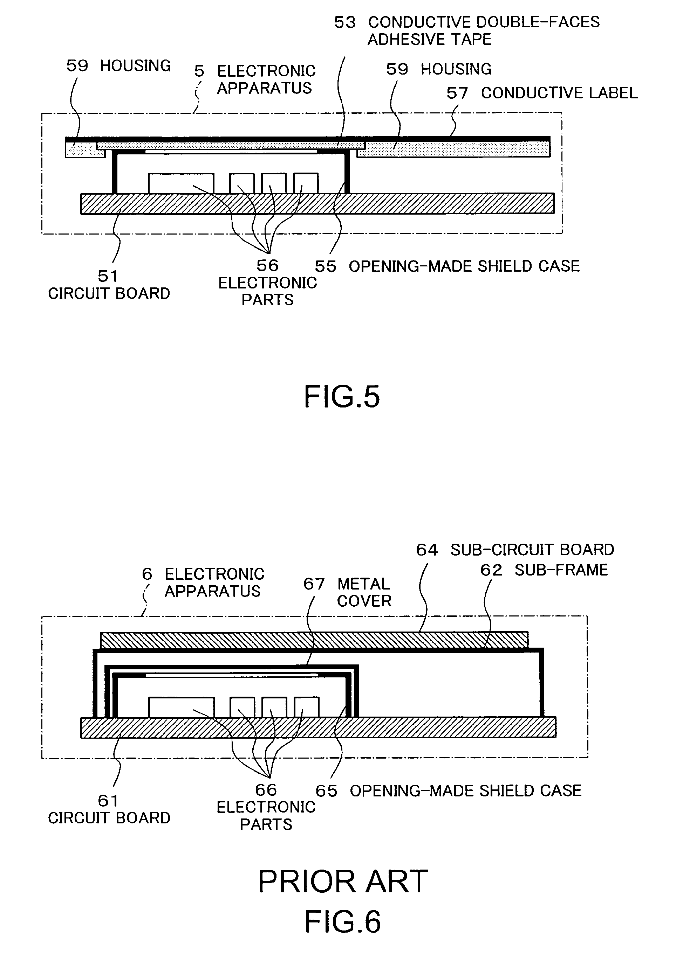

As a method of solving the above-described problem, there is a method of disposing the shield not on the entire circuit board but on the periphery of the electronic parts on the circuit board. The shield which surrounds the electronic parts in this method becomes one of parts mounted on the circuit board together with the electronic parts. Such a conventional example is shown in FIG. 6. FIG. 6 is a schematic cross-sectional view of the example.

In FIG. 6, a shield case 65 covers electronic parts 66 on a circuit board 61. This is for the purpose of shielding electromagnetic waves emitted from the electronic parts 66. The shield case 65 has an opening. This opening is provided for, in the same assembly step, mounting the shield case 65 on the board 61, and mounting the electronic parts 66 on the board 61. Without the opening, it is difficult to perform the mounting of the electronic parts 66 and the mounting of the shield case 65 in the same manufacturing step. A metal cover 67 seals the opening in order to shield the electromagnetic waves which leak from the opening. A sub-frame 62 is further provided on the metal cover 67. This is another structural component in the electronic apparatus. In FIG 6, the sub-frame 62 supports a sub-circuit board 64. The sub-circuit board 64 is a circuit board provided separately from the circuit board 61. For example, the sub-circuit board 64 is a peripheral circuit of a display element such as a liquid crystal display (LCD), a peripheral circuit of an input element such as a key pad, and the like. In some cases, not only the peripheral circuit but also a functional part such as the LCD or the key pad is mounted on the sub-circuit board 64.

In the conventional example of FIG. 6, the shielding of the electromagnetic waves and the supporting of the sub-circuit board are achieved by a triple layer structure of the shield case 65, the metal cover 67, and the sub-frame 62. Accordingly, the conventional example has a problem in that thickness, weight, and cost of the electronic apparatus are increased.

### SUMMARY OF THE INVENTION

The present invention has been proposed to solve the above-described problems, and it is an object of the present invention to provide an electronic apparatus having a shield structure which shields the electromagnetic waves emitted from an inside of the electronic apparatus and is capable of maintaining a mechanical strength of the entire electronic apparatus while reducing the thickness, weight, andcostthereof.

To attain the above object, according to the present invention, an electronic apparatus, which includes an electromagnetic shield case supported on a circuit board, and a conductive component electrically connected to the electromagnetic shield case, for intimately contacting and sealing a gap of the electromagnetic shield case, is provided.

### BRIEF DESCRIPTION OF THE DRAWINGS

The above and other objects, features and advantages of the present invention will become apparent from the following detailed description when taken in conjunction with the accompanying drawings wherein:
FIG. 1 is a schematic cross-sectional view of a key structure portion and shield structure portion of an electronic apparatus according to a first embodiment of the present invention;
FIG. 2 is a schematic cross-sectional view of a key structure portion and shield structure portion of an electronic apparatus according to a second embodiment of the present invention;
FIG. 3 is a schematic cross-sectional view of a housing structure portion and shield structure portion of an electronic apparatus according to a third embodiment of the present invention;
FIG. 4 is a schematic cross-sectional view of a housing structure portion and shield structure portion of an electronic apparatus according to a fourth embodiment of the present invention;
FIG. 5 is a schematic cross-sectional view of a housing structure portion and shield structure portion of an electronic apparatus according to a fifth embodiment of the present invention; and
FIG. 6 is a schematic cross-sectional view of a wireless terminal of a conventional example, inside of which a shield structure is provided.

### DETAILED DESCRIPTION OF THE PREFERRED EMBODIMENTS

Next, embodiments of the present invention will be described with reference to the drawings.

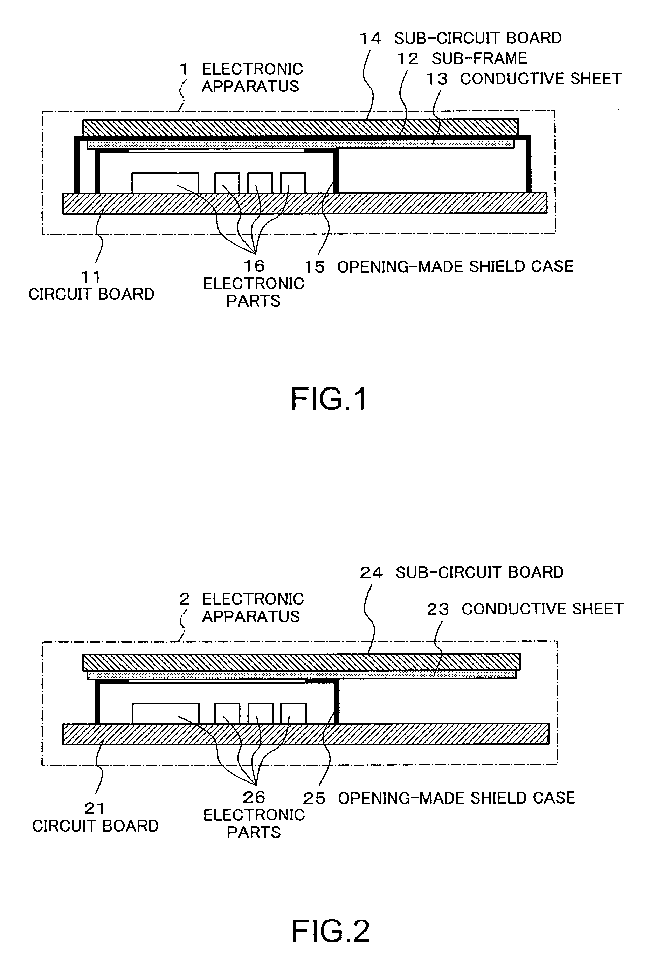

FIG. 1 is a schematic cross-sectional view of a shield structure portion of an electronic apparatus according to a first embodiment of the present invention. A circuit board 11, electronic parts 16, an opening-made shield case 15, a sub-circuit board 14, a sub-frame 12, and a conductive sheet 13 are shown in FIG. 1. The electronic parts 16 mounted on the circuit board 11 are, for example, an integrated circuit (IC) , a transistor, a capacitor, a resistor, and the like. The opening-made shield case 15 mounted on the circuit board 11 surrounds the electronic parts 16. The opening-made shield case 15 has conductivity and electromagnetic shielding property, and shields electromagnetic waves emitted from the electronic parts 16. The opening-made shield case 15 has an opening for assembly work. The sub-frame 12 is a structural component of the electronic apparatus 1. For example, the sub-frame 12 is a structural component constructing a housing, or a support component which holds parts of the electronic apparatus 1. Here, a description will be made of the sub-frame 12 by taking as an example the case of supporting the sub-circuit board 14. The sub-circuit board 14 is a circuit board for, for example, a key pad, a display element, and peripheral elements thereof. The sub-circuit board 14 is a separate component from the circuit board 11. The sub-frame 12 supported on the circuit board 11 supports the sub-circuit board 14. The sub-frame 12 may not be necessarily supported on the circuit board 11 depending on the structure of the electronic apparatus. The sub-frame 12 has conductivity and electromagnetic shielding property as well as a mechanical strength for supporting the sub-circuit board 14. For example, the sub-frame 12 may be made of metal. The conductive sheet 13 is located between the periphery of the opening of the opening-made shield case 15 and a lower surface of the sub-frame 12.

After being assembled, with regard to the conductive sheet 13, one and the other surfaces thereof are brought into intimate contact with the lower surface of the sub-frame 12 and the periphery of the opening of the opening-made shield case 15, respectively.

In this embodiment, the other surface of the sub-frame 12 seals the opening of the opening-made shield case 15 through the conductive sheet 13. At the same time, the conductive sheet 13 comes into intimate contact with both of the shield case 15 and the sub-frame 12, and electrically connects them together. As a result, the shield case 15 and the sub-frame 12 become one electrical element. In such a way, the sub-frame 12 electrically connected to the opening-made shield case 15 seals the opening of the opening-made shield case 15, and achieves electromagnetic shielding (the shielding of the electromagnetic waves) at the opening of the opening-made shield case 15.

When the sub-circuit board 14 is a thin flexible board component, the sub-circuit board 14 does not have a mechanical strength. In such a case, a structural component for supporting the sub-circuit board 14 in the housing becomes necessary. For example, the mechanical strength becomes further necessary for the sub-circuit board 14 on which the key pad is mounted. This is because a mechanical stress when the key pad is depressed acts on the sub-circuit board 14. In this embodiment, the sub-frame 12 plays both roles, the structural component and shielding component for electromagnetic waves. The first embodiment of the present invention is characterized in that the sub-frame 12 is used as the structural reinforcement component, and also used for the purpose of shielding the electromagnetic waves emitted through the opening of the opening-made shield case 15.

As shown in FIG. 1, the conductive sheet 13 is pasted onto the sub-frame 12, and is brought into intimate contact with the opening-made shield case 15, and an effect of the shield case and an effect of the sub-frame are thus realized by one metal sheet. As apparent from comparison with the conventional example shown in FIG. 6, the metal cover 67 of the conventional example can be eliminated, leading to an effect for thinning, weight saving, and cost reduction of the electronic apparatus 1.

Here, the conductive sheet 13 in FIG. 1 may be replaced by a conductive double-faced adhesive tape. The sub-frame 12 and the opening-made shield case 15 are adhered to each other by the conductive double-faced adhesive tape, thus making it possible to enhance the mechanical strengths of both.

Alternatively, if it is possible to sufficiently ensure the electrical connection between the sub-frame 12 and the opening-made shield case 15, the sealing of the opening, and the mechanical strengths of the sub-frame 12, then a configuration may also be adopted in which the sub-frame 12 and the opening-made shield case 15 come into intimate contact directly with each other without using the conductive sheet 13 or conductive double-faced adhesive tape.

Next, a second embodiment of the present invention will be described with reference to the drawing. FIG. 2 is a schematic cross-sectional view of an electronic apparatus according to the second embodiment of the present invention. In the electronic apparatus 1 of the first embodiment, the sub-circuit board 14 is supported by the sub-frame 12. In the electronic apparatus 2 of the second embodiment, a sub-circuit board 24 is a circuit board having some thickness and mechanical strength. Hence, asub-frameforsupporting mechanically thesub-board 24 or other components in the housing is not necessary. Another means supports the sub-circuit board 24 or other components mechanically in the housing of the electronic apparatus 2.

In the second embodiment, a conductor is exposed to a backside of the sub-circuit board 24. A conductive sheet 23 is directly pasted onto the backside of the sub-circuit board 24, where the conductor is exposed. Further, the conductive sheet 23 comes into intimate contact with an opening-made shield case 25. The conductive sheet 23 electrically connects the opening-made shield case 25 and the conductor exposure part of the sub-circuit board 24 to each other. The sub-circuit board 24 seals an opening of the opening-made shield case 25 through the conductive sheet 23. With such a construction of the opening-made shield case 25, the sub-circuit board 24, and the conductive sheet 23, the electromagnetic shielding is achieved.

As apparent from comparison with the conventional example shown in FIG. 6, the metal cover 67 of the conventional example can be eliminated in this embodiment. Further, in this embodiment, the sub-frame can also be eliminated in comparison with the first embodiment. This embodiment has an effect for thinning, weight saving, and cost reduction of the electronic apparatus 2.

Here, the conductive sheet 23 in FIG. 2 may be replaced by the conductive double-faced adhesive tape. The sub-circuit board 24 and the opening-made shield case 25 are adhered to each other by the conductive double-faced adhesive tape, thus making it possible to enhance the mechanical strengths of both.

Alternatively, if it is possible to sufficiently ensure the electrical connection between the sub-circuit board 24 and the opening-made shield case 25, the sealing of the opening, and the mechanical strengths of the sub-circuit board 24, then a configuration may also be adopted in which the sub-circuit board 24 and the opening-made shield case 25 come into intimate contact directly with each other without using the conductive sheet 23 or conductive double-faced adhesive tape.

In the first and second embodiments, the shielding effects for the opening-made shield cases 15 and 25 are obtained by using the sub-frame 12 and the sub-circuit board 24 without using the metal cover 67. When the housing is made of a conductive material, the conductive housing can be used instead of the sub-frame 12 and the sub-circuit board 24. Such a case will be described in the following third embodiment.

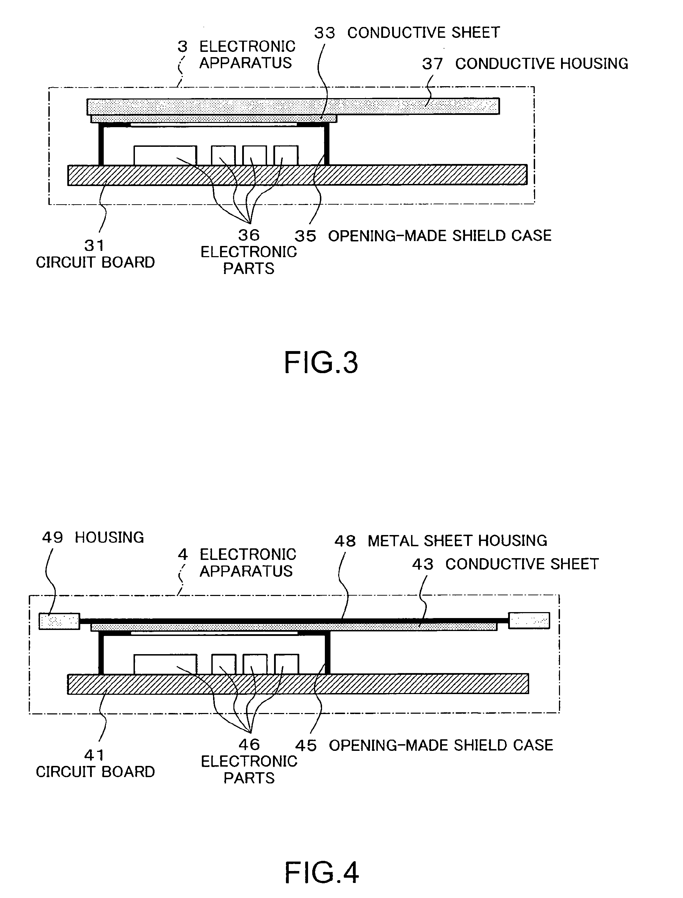

The third embodiment of the present invention will be described with reference to the drawing. FIG. 3 is a schematic cross-sectional view of a housing structure portion and shield structure portion of an electronic apparatus according to the third embodiment of the present invention. In the electronic apparatus 3 of the third embodiment, a conductive sheet 33 is pasted onto a backside of a conductive housing 37. Further, the conductive sheet 33 comes into intimate contact with an opening-made shield case 35. In such a way, the opening-made shield case 35 and the conductive housing 37 are electrically connected to each other. Further, an opening of the opening-made shield case 35 is hermetically sealed by the conductive housing 37. With such a construction, the electromagnetic shielding is achieved by the opening-made shield case 35 and the conductive housing 37.

Also here, as apparent from comparison with the conventional example shown in FIG. 6, the metal cover 67 of the conventional example can be eliminated. This embodiment has an effect for thinning, weight saving, and cost reduction of the electronic apparatus 3. Further, it is also possible to eliminate for the sub-frame 12 and the sub-circuit board 24 to be located at the position to seal the opening of the opening-made shield case 35 as in the first and second embodiments. It is made possible to reduce limitations on designing the electronic apparatus 3, and to increase a degree of freedom therein.

Here, the conductive sheet 33 in FIG. 3 may be replaced by the conductive double-faced adhesive tape. The conductive housing 37 and the opening-made shield case 35 are adhered to each other by the conductive double-faced adhesive tape, thus making it possible to enhance the mechanical strengths of them.

Alternatively, if it is possible to sufficiently ensure the electrical connection between the conductive housing 37 and the opening-made shield case 35, the sealing of the opening, and the mechanical strengths of the conductive housing 37 and the opening-made shield case 35, then a configuration may also be adopted in which the conductive housing 37 and the opening-made shield case 35 come into intimate contact directly with each other without using the conductive sheet 33 or conductive double-faced adhesive tape.

Next, a fourth embodiment of the present invention will be described with reference to the drawing. FIG. 4 is a schematic cross-sectional view of a housing structure portion and shield structure portion of an electronic apparatus according to the fourth embodiment of the present invention. In the fourth embodiment, a portion of a housing 49, which faces to an opening-made shield case 45, is a conductive metal sheet housing 48 thinner than the housing 49. A conductive sheet 43 is pasted onto a backside of the metal sheet housing 48. Further, the conductive sheet 43 comes into intimate contact with the opening-made shield case 45. In such a way, the conductive sheet 43 electrically connects the opening-made shield case 45 and the metal sheet housing 48 to each other. At the same time, the metal sheet housing 48 seals an opening of the opening-made shield case 45 through the conductive sheet 43. Thus, the effect of the electromagnetic shielding is achieved by the opening-made shield case 45, the conductive sheet 43, and the metal sheet housing 48.

Also here, as apparent from comparison with the conventional example shown in FIG. 6, the metal cover 67 of the conventional example can be eliminated, leading to an effect for thinning, weight saving, and cost reduction of the electronic apparatus 4. Further, in this case, it is made possible to thin the electronic apparatus as compared with the third embodiment by the amount that the thickness of the housing is thinned.

Here, the conductive sheet 43 in FIG. 4 may be replaced by the conductive double-faced adhesive tape. The metal sheet housing 48 and the opening-made shield case 45 are adhered to each other by the conductive double-faced adhesive tape, thus making it possible to enhance the mechanical strengths of them.

Alternatively, if it is possible to sufficiently ensure the electrical connection between the metal sheet housing 48 and the opening-made shield case 45, the sealing of the opening, and the mechanical strengths of the metal sheet housing 48 and the opening-made shield case 45, then a configuration may also be adopted in which the metal sheet housing 4 8 and the opening-made shield case 45 come into intimate contact directly with each other without using the conductive sheet 43 or conductive double-faced adhesive tape.

Next, a fifth embodiment of the present invention will be described with reference to the drawing. FIG. 5 is a schematic cross-sectional view of a housing structure portion and shield structure portion of an electronic apparatus according to the fifth embodiment of the present invention.

In the fifth embodiment, there is an opening in a portion of a housing 59, which faces to an opening-made shield case 55. The housing 59 is formed into a structure capable of supporting the opening-made shield case 55. In FIG. 5, a structure in which the housing 59 has a step difference for fitting and supporting the opening-made shield case 55 thereinto is shown as an example of the structure capable of supporting the opening-made shield case 55. With this construction, the opening-made shield case 55 is supported on the opening of the housing 59. At the same time, a conductive double-faced adhesive tape 53 is pasted onto the opening-made shield case 55 so as to be brought into intimate contact therewith. Further, a conductive label 57 is pasted onto the conductive double-faced adhesive tape 53. In such a way, the conductive double-faced adhesive tape 53 electrically connects the opening-made shield case 55 and the conductive label 57 to each other. At the same time, the conductive label 57 seals the opening of the housing 59 and an opening of the opening-made shield case 55, and achieves the electromagnetic shielding. Specifically, the effect of the electromagnetic shielding is achieved by the opening-made shield case 55, the conductive double-faced adhesive tape 53, and the conductive label 57.

In this embodiment, it is the conductive double-faced adhesive tape 53 and the conductive label 57 that seal the opening of the opening-made shield case 55. The tape and the label do not have such high strengths as the frames and the boards with some thickness in the embodiments mentioned above. Therefore, this embodiment is suitable for a situation where the periphery of the opening of the opening-made shield case 55 does not require such a high strength. For example, the situation includes a case where the opening of the housing 59 is located under an attachment portion of a battery pack. The battery pack is attached onto the opening of the housing 59, and further, a cover of the attachment portion of the battery pack is attached thereonto. When the housing is formed into such a structure, the opening of the housing 59 is hidden under the cover and the battery pack and is not directly exposed to the outside at the time of normal use of an electronic apparatus 5. Hence, in this case, such a high strength as in the case where the opening of the housing 59 is always exposed directly to the outside is not necessary. As described above, this embodiment is suitable for the case where such strengths of the tape and the label satisfactorily meet the requirement.

Here, if it is possible to sufficiently ensure the electrical connection between the conductive label 57 and the opening-made shield case 55, the sealing of the opening, and the mechanical strengths of the conductive label 57 and the opening-made shield case 55, then a configuration may also be adopted in which the conductive label 57 and the opening-made shield case 55 come into intimate contact directly with each other without using the conductive double-faced adhesive tape 53.

Further, if there is another means for supporting the conductive label 57 on the opening and intimately contacting the conductive label 57 therewith besides the adhesion by the conductive double-faced adhesive tape 53, not the conductive double-faced adhesive tape but the conductive sheet may be used.

Also here, as apparent from comparison with the conventional example shown in FIG. 6, the metal cover 67 of the conventional example can be eliminated. This brings an effect for thinning, weight saving, and cost reduction of the electronic apparatus 5. Further, in this case, it is made possible to thin the terminal as compared with the fourth embodiment by the amount that the thickness of the portion opposite to the opening-made shield case 55 is further thinned.

Note that, in the first to fifth embodiments, descriptions have been made of cases where the present invention is applied to the circuit board surface on which the electronic parts are mounted. Further, FIGS. 1 to 5 corresponding to the first to fifth embodiments also show the cases where the present invention is applied to the circuit board surface on which the electronic parts are mounted. However, in any of the embodiments, the present invention is also applicable to a circuit board surface on which the electronic parts are not mounted. Alternatively, the present invention is also applicable to both surfaces of the circuit board no matter whether or not the electronic parts are mounted thereon.

The present invention can realize a function of the shield case and a function to maintain the mechanical strength by one metal sheet, and accordingly, has the effect for the thinning, weight saving, and cost reduction of the electronic apparatus having the shield structure.

The present invention is characterized by using the shield for improving radio characteristics also as the mechanical reinforcement. Specifically, the present invention is characterized in that the conductive sheet or the conductive double-faced adhesive tape, which is for use in sealing the opening, is mounted between the opening-made shield case and the shield plate.

While this invention has been described in connection with certain exemplary embodiments,. it is to be understood that the subject matter encompassed by way of this invention is not to be limited to those specific embodiments. On the contrary, it is intended for the subject matter of the invention to include all alternatives, modifications and equivalents as can be included within the spirit and scope of the following claims.

Further, it is the inventor's intent to retain all equivalents of the claimed invention even if the claims are amended during prosecution.

## Claims

1. An electronic apparatus, comprising:
an electromagnetic shield case supported on a circuit board; and
a conductive component electrically connected to the electromagnetic shield case, for intimately contacting and sealing a gap of the electromagnetic shield case.

2. The electronic apparatus according to claim 1, wherein between the electromagnetic shield case and the conductive component, at least one of a conductive sheet and a conductive double-faced adhesive tape is disposed.

3. The electronic apparatus according to claim 1 or 2,wherein the conductive component is a frame for supporting a sub-circuit board.

4. The electronic apparatus according to claim 1, wherein the conductive component is a sub-circuit board which exposes a conductor portion which comes into intimate contact with the electromagnetic shield case, and electrically connects thereto.

5. The electronic apparatus according to claim 2, wherein the conductive component is a sub-circuit board which exposes a conductor portion which comes into intimate contact with at least one of the conductive sheet and the conductive double-faced adhesive tape, and electrically connects thereto.

6. The electronic apparatus according to claim 1 or 2,wherein the conductive component is a housing which has conductivity.

7. The electronic apparatus according to claim 1 or 2, wherein the conductive component is a part of a housing which has conductivity.

8. The electronic apparatus according to claim 1 or 2, wherein the conductive component is a conductive label.
